(19) **Europäisches Patentamt European Patent Office Office européen des brevets**

(11) **EP 1 139 110 B1**

(12) **EUROPEAN PATENT SPECIFICATION**

(45) Date of publication and mention of the grant of the patent:
**11.11.2009 Bulletin 2009/46**

(51) Int Cl.:
***G01R 33/34*** *(2006.01)*

(21) Application number: **01302547.3**

(22) Date of filing: **19.03.2001**

(54) **Device with field-modifying structure**

Gerät mit einer feldändernden Struktur

Appareil avec une structure modifiant des champs

(84) Designated Contracting States:
**AT BE CH CY DE DK ES FI FR GB GR IE IT LI LU MC NL PT SE TR**

(30) Priority: **21.03.2000 US 532145**
**21.03.2000 US 532667**
**21.03.2000 US 532037**

(43) Date of publication of application:
**04.10.2001 Bulletin 2001/40**

(73) Proprietor: **Image-Guided Neurologics, Inc.**
**Melbourne, FL 32935 (US)**

(72) Inventors:
• **Viswanathan, Raju R.**
**Towson,**
**Maryland 21204 (US)**

• **Ragavahan, Raghu**
**Baltimore,**
**Maryland 21210 (US)**

(74) Representative: **Bowman, Paul Alan**
**Marks & Clerk LLP**
**90 Long Acre**
**London**
**WC2E 9RA (GB)**

(56) References cited:
**EP-A- 0 928 972      WO-A-99/10035**
**US-A- 5 357 958**

• **G.C. HURST ET AL.: "Intravascular (Catheter) NMR Receiver Probe..." MAGNETIC RESONANCE IN MEDICINE, vol. 24, 1992, pages 343-357, XP000275075**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention relates to devices and particularly medical devices for the reception of electromagnetic radiation. These devices are used (generally at radio frequencies) to obtain a variety of field responses in field-of-view magnetic resonance images of a localized regions within a natural organism (such as within a human). Medical devices may be used in conjunction with such magnetic resonance imaging devices, such as catheters and other devices for delivery of drugs and other therapeutic agents to areas of interest within the body or in an artificial environment.

Throughout this specification, the term MR is used to mean Magnetic Resonance and MR microcoil is used to denote a magnetic resonance device used for imaging from within a patient. MR coils are conventionally used externally to the body in order to generate MR images, while the MR microcoil may be mounted at the tip of a catheter or other insertion device used commonly to probe the interior of a body so as to provide quick and direct access to the region where imaging is required. It is essential during the course of medical procedures such as image-guided and minimal access surgery, performed within small regions of a patient's anatomy, to be able to visualize the procedure being performed by the surgeon and the neighborhood of the anatomical region being treated surgically. While several methods, including x-ray imaging and fiber optic viewing offer possible alternative means of performing the visualization, magnetic resonance imaging methods are a particularly convenient means of doing this, especially given the highly localized nature of the procedures being performed. Extended x-ray exposures are harmful to the patient, and fiber optic viewing is not well suited either to viewing within small confines or to volume visualization. Both of these limitations may be circumvented by magnetic resonance imaging.

U.S. Patent Nos. 6,026,316 and 6,061,587 describe the use of improved Magnetic Resonance Imaging (MRI) techniques and devices enables a real-time visualization of compositional changes in the molecular composition of small regions within patients. The compositional changes may be caused by delivery of drugs or active chemicals, or by the stimulation of local chemical production by tissues or organs in the patient. MRI can actually enable visualization of minute concentration changes within the body, particularly intracranial regions of the patient.

U.S. Patent Number 5,271,400 describes a tracking system for the position and orientation of an invasive device within a patient. The device includes a receiver coil and an MR active sample.

In AMR imaging of blood vessels with an intravascular coil', J. Mag. Res. Imag., 1992, Vol. 2, pages 421-429, A.J. Martin, D.B. Plewes and R.M. Henkelman describe an opposed solenoid design for an intravascular MR microcoil. This paper describes microcoils made of a pair of helical windings arranged in opposed fashion at the tip of a catheter, shown to be suitable for magnetic resonance imaging purposes. The term opposed coil means a coil in which the relative winding of two coil segments is opposite in sense, and the current flow in each opposed coil winds in opposite directions about the coil axis (relative to moving towards or away from the core or axis of the coil). That is, viewing the coils looking down an axis of the core around which the coils are disposed, one will be wrapped clockwise and the other will be wrapped counterclockwise, with a common lead between the two segments. The field-of-view of this coil is roughly cylindrical about the opposed solenoidal windings. The coil is essentially radio frequency insensitive beyond the longitudinal extent of the windings since the magnetic field in this design is squeezed out of the gap between the windings and is only significantly large in a cylindrical region that does not extend too far beyond this gap.

E. Atalar et al. describe a catheter receiver coil in 'High resolution MRI and MRS by using a catheter receiver coil', Mag. Res. Med., 1996, Vol. 36, pages 596-605. The gain of this coil falls off rapidly with distance from the coil so that noise levels in an image adjusted for the signal may still vary widely across the image.

International Patent Application No. PCT/US98/17076 published as WO99/10035 discloses a device adapted for insertion within an organism during a magnetic resonance procedure, said device comprising at least one pair of opposed RF receiver microcoils having a space between each microcoil of said pair of microcoils.

U.S. Patent No. 5,964,705 describes an opposed solenoid design for an MR microcoil with helical windings whose pitch varies along the length of the winding with the aim of achieving homogeneity. However, the optimization method given there for finding a suitable pitch variation assumes a 'sheet current' distribution of the current along the catheter tip, which may not be realized in practice. Accordingly, the homogeneity of the field produced by the microcoil can be improved by other means, such as the invention described and claimed herein.

In summary, while microcoils for such internal imaging have been described before, the said device here has been designed specifically for very significant homogeneity of the radial magnetic field around the MR microcoil and a concomitant optimal sensitivity and signal strength of the received signal. This tends to provide a uniformly large field-of-view within which the said device provides a strong signal-to-noise ratio that is useful for imaging purposes.

## SUMMARY OF THE INVENTION

According to the present invention there is provided a device adapted for insertion within an organism during a magnetic resonance procedure, said device comprising:

a RF coil for magnetic resonance imaging adapted for use on a device to be inserted into a patient, the RF coil comprising:

at least one pair of coils being wound in helical and in opposite sense;
said pair of coils being arranged along a common longitudinal axis;
said pair of coils having a space along said common longitudinal axis between them;
said RF coil being **characterized in that:**

the winding diameter of each coil increases with increasing actual distance from the other coil from said pair of coils.

## BRIEF DESCRIPTION OF THE INVENTION

A microcoil configuration, preferably on a medical device to be inserted into a patient, has an opposed pair of microcoils. At least one or each microcoil of the opposed pair of microcoils has at least a region where a diameter circumscribed by a first winding is greater than the diameter circumscribed by at least one complete second winding, especially an adjacent winding displaced from the first winding along an axis or core of the medical device or an axis of the microcoil. The second winding is nearer to or farther from an intermediate region between the microcoils that define the pair of microcoils. For example, it is common to have a connecting (usually straight or non-wound) lead between the two microcoils, and this lead may be used to define an intermediate region. The microcoil configuration with varying circumference between windings (especially adjacent windings) is generally referred to herein as a dumb-bell or horn configuration because of its general appearance and the individual microcoils are referred to as a horn microcoil, again because of the visual appearance of the microcoil.

Figure 1 shows a side view of one embodiment of a microcoil according to the present invention described in detail below.
Figure 2 shows a three-dimensional plot of the microcoil geometry where the varying cross-section of the microcoil is easily discernible.
Figure 2A shows a plot of the transverse magnetic field in a 2cm $\times$ 2cm planar region placed symmetrically about the axis of the coil at a distance of 1cm forward from the distal end of the coil.
Figure 2B shows a semi-logarithmic plot of the transverse magnetic field profile at a given cross section (at two-tenths of the coil length) through the microcoil,
Figure 3 shows plots of the transverse magnetic field profile at different orientations around the coil section, at a certain fixed distance (eg of three times the coil's outer end radius) from the coil axis.
Figure 3A indicates the location with respect to the coil of the planar region chosen to make the plot in Figure 2A. For clarity, the variation in transverse magnetic field intensity across the chosen planar region is shown here as a variation in color within the slice.
Figure 3B shows a semi-logarithmic plot of the transverse magnetic field at a transverse cross-section passing through the middle of the microcoil.
Figure 4 shows plots of the transverse magnetic field at different orientations around the coil section, at a fixed distance (of five times the coil's outer end radius) from the coil axis.
Figure 4A shows a plot of the transverse magnetic field in a 2cm x 2cm planar region placed symmetrically about the axis of the coil at a distance of 2cm forward from the distal end of the coil.
Figure 4B shows a depiction of the field of view of the microcoil in comparison to its size.
Figure 5 shows some alternative winding constructions within the practice of the present invention.
Figure 6A shows a plot of the transverse magnetic field in a 2cm x 2cm planar region when two spiral pairs are used, with the planar region placed symmetrically about the axis of the coil at a distance of 1cm forward from the distal end of the coil.
Figure 6B also shows an alternative winding construction within the practice of the present invention. ,

The practice of certain aspects of the present invention is applicable to all medical devices which might be used with magnetic resonance imeging-based viewing procedures occurring concurrently with the primary medical procedure. Features of the present invention which may individually have this general applicability within the medical device field include the types of RF-responsive coils and associated circuitry provided to medical devices to assure their MR-compatibility, and means for directing the said microcoil within or with a catheter device. The preferred construction uses a pair of opposed, non-uniformly-cylindrical coaxial coils with varying cross section and separated by a space, with the current flowing in opposite (rotationally angularly opposite, not linearly opposite with respect to the axis of the center of the microcoils or catheter) senses in the two coils. The two opposed coils may be connected by a bridging conductor (also referred to herein as an intermediate zone) so that the entire configuration is built from a single conductor. Thus, when that configuration is viewed from one end of the common coil axis, the currents in the two coils are such that the current direction in one of the coils is clockwise around this axis and that in the other is anticlockwise (counterclockwise) around the axis. This is due to the opposite sense of winding of the conductor used in the coils.

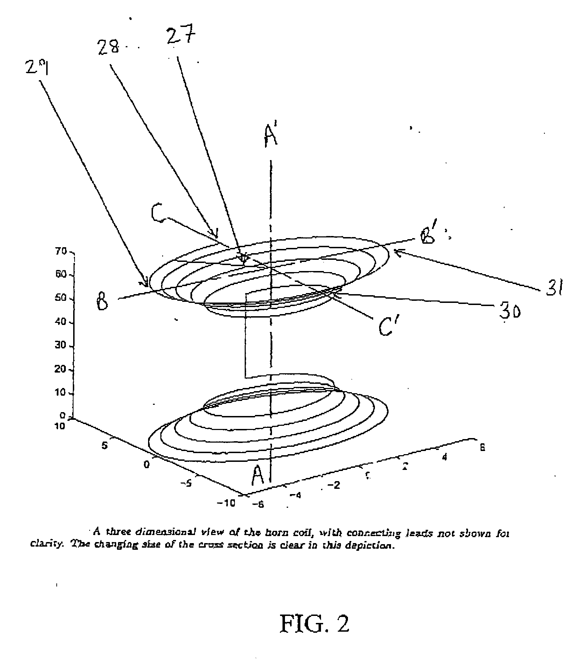

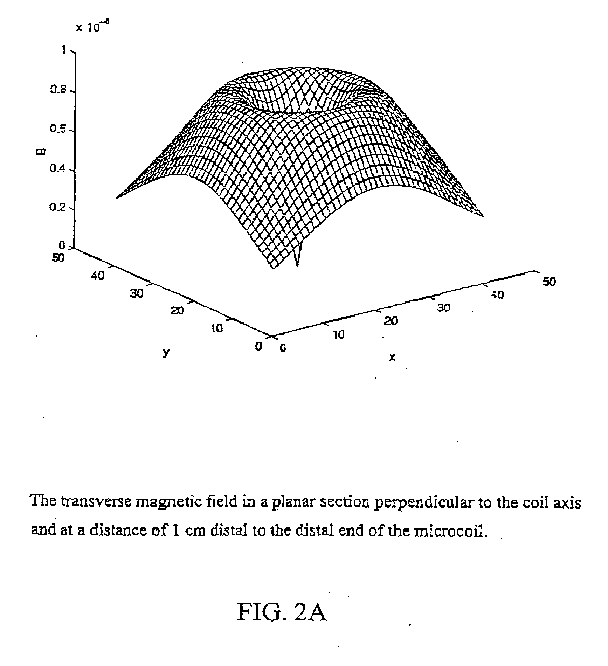

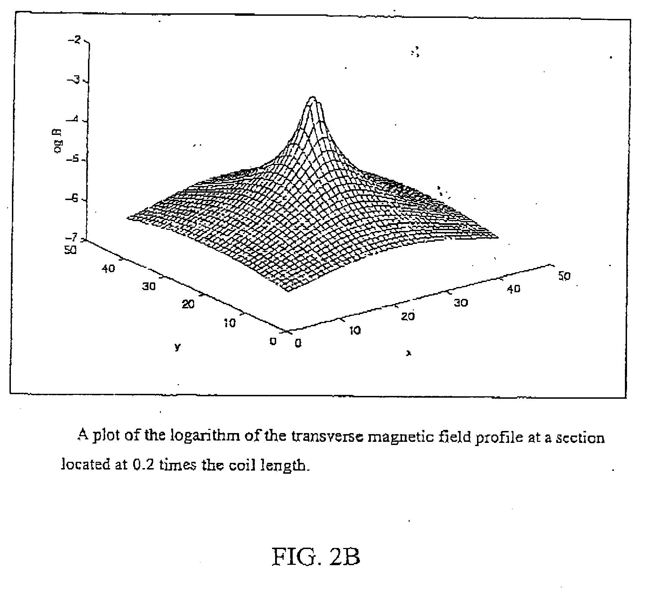

Although this opposite sense of windings is generally used in the constructions of the present invention, it is clearly possible to further alter the structural configurations (and hence the resultant field) by other configurations still using a horn shaped microcoil(s). For example, the connections have been heretofore specifically described as between a pair of microcoils from interior to interior sections or leads of the individual microcoils (as shown in Figure 2, between the smallest windings of both microcoils). In alternative embodiments still characterized by the presence of at least one horn-shaped microcoil, the electrical connection between adjacent microcoils or separate electrical leads to adjacent microcoils, at least one of which is horn-shaped, may comprise connectors from exterior-to-exterior positions of the microcoils, interior-to-exterior positions, or exterior-to-interior position on adjacent microcoils. For example, the connections may be between a largest diameter position winding on a microcoil to the smallest diameter winding on an adjacent microcoil, or between the largest windings of both microcoils or between the smallest windings on the adjacent microcoils. The visible appearance along an axis (e.g., A-A=) would >see= the coils as a) clockwise and counterclockwise, b) clockwise and clockwise, c) counterclockwise and counterclockwise or d) counterclockwise and clockwise when constructed from amongst these various mechanisms of electrical interconnection between adjacent microcoils or with separate electrical connections among the microcoils.

As noted earlier, there may be a single horn shaped microcoil, a pair of adjacent microcoils where at least one is horn-shaped, a pair of microcoils where both are horn-shaped, multiple pairs of microcoils in which at least one microcoil or microcoil pair is horn-shaped, and the like. Each use of a horn-shape microcoil will alter the response field in the novel manner described herein.

A unique feature of the present invention is the non-cylindrical nature of the horn-shape microcoil and the winding due to the changing winding radius along the coil axis. This permits designing the field for maximal homogeneity within a cylindrical spatial region surrounding the coil and allows for more variations among vertical and horizontal spacing of the windings and degrees of control over the shape of the responsive field. While many alternative variations of the winding radius are possible, a radius variation in which the radius is greatest at the outer end of each coil of the opposed coil pair and is least at the inner end of each coil is found to be most optimal. There may be some >collapse= (or reduced winding diameter) at the large end of the horn or a bulge at the smallest end of the horn, without any significant variation from the practice of the present invention. In fact, such geometries may be necessary because of design issues in certain medical instrument constructions. The envelope of the winding profile is horn shaped in this configuration. The shape of this horn may be chosen to follow different profiles, although that of a quarter sine wave is most preferred. The lack of a perfect, uniform, traditional, tubelike cylindrical nature of the microcoil winding in the present invention, which novel configuration produces magnetic field lines whose radial components outside the microcoil are distributed over and around a significant proportion of the length of the microcoil, is a fundamental principle behind the present invention, and may be efficiently used to yield a significantly uniform field profile, constituting a substantial advance in the design of such devices. This unique design may be used in combination with other design and structure variables within the coil, microcoil and winding configurations. Among the non-exclusive design variations that may be used are a) variable winding thickness, b) variable diameters, c) variable winding translation and separation along the microcoil axis, d) varying rate of diameter increase along the microcoil axis, e) the number of microcoil pairs, f) and the combination of different microcoil geometries in combination with at least one horn-shape microcoil.

There are certain terms used in the description of the present invention that should be defined to assist in a better understanding of the invention. A coil or microcoil is a set of wires or electrical elements forming a continuous conducting path around a device. The coils or microcoils comprise at least windings or wires that form the structural content of the coils or microcoils. The windings or wires have a thickness (which can be referred to as a diameter or cross-section, but will be referred to as a thickness) and the windings as they form the coils or microcoils form shapes that have a diameter (loci of distances) about a core or axis of the device around which the windings pass. The space between adjacent windings can be measured in three different ways. The space between windings can be measured linearly along the axis of the core of the windings (equivalent to measuring the Z value in a two dimension graph), by vertical separation (equivalent to measuring the Y value in a two dimensional graph), and by direct linear separation (equivalent to measuring the literal distance between points on a two dimension graph [e.g., {the distance may be physically measured of by taking the square root of $(Z_1-Z_2)^2 + (Y_1-Y_2)^2$}]). The three different distances shall be referred to as the Z distance, the Y distance and the literal distance, respectively. As the windings move along the Z direction, their diameters at any point along the winding (with respect to the axis of the microcoil or device) vary from adjacent windings at the same rotational position (an angle of rotation, clockwise or counterclockwise, with respect to a reference $0^\circ$ position looking down the axis of the coil or microcoil). When the term diameter of a winding or diameter of a single wrap of the microcoil is used, that diameter can be measured (especially in comparison to the adjacent winding diameter) at a specific angle or rotation (with the same angle of rotation used in comparing adjacent winding diameters) or by averaging (by integration) the diameter of a complete encircling of the axis by a winding. These terms will be referred to herein as adjacent diameters and average diameters, respectively. The Z distance between adjacent windings within a microcoil will be referred to herein as a frequency, expressed as either distance (that is distance between windings) or as windings per linear Z distance.

One general description of the present invention may be as a device for use within an organism, the device comprising an element having at least one pair of opposed RF receiver microcoils having a space (usually measured along the Z axis, parallel to the axis of the microcoil or core of the device) between each microcoil of the pair of microcoils. The coils of the microcoils comprise at least one adjacent pair of windings on at least one microcoil in which a diameter of one winding on the at least one microcoil increases in winding diameter with respect to a diameter of an adjacent winding. This increase in adjacent diameter is seen as adjacent windings are compared along the Z axis. Increased benefits are obtained when at least some progressive windings have progressively increasing diameters in this construction. It is not essential that every winding in the series of windings that form the microcoil increase in average diameter as compared to the average diameter of the adjacent winding. The increases may be in step form, with one or two adjacent pairs of windings having the same diameter, or even one pair decreasing in average diameter as the general trend of the windings is to increase in average diameter. The device may, for example, comprise a catheter having at least one lumen, and the at least one horn-shape microcoil or the at least one pair of microcoils is radially located about the at least one lumen and the windings have thicknesses of greater than 0.1 mm. At least some of the windings may have a diameter of greater than 0.1 mm and less than 2.4 mm. A particularly useful device has at least one drug delivery port present within said device. A particularly good location for the at least one drug delivery port is a position where at least some drug which is delivered through the port is delivered away from the device within a space between said pair of opposed microcoils. One additional design benefit is to have at least some microcatheters present within said device which extend outside of said device to deliver at least some liquid material within a volume bordered by planes extending radially from the catheter (at ends of the at least one pair of microcoils). The volume where the liquid material could be defined as between these planes, the surface of the catheter and a distance of anywhere from 0.1 to 6 mm from the surface of the catheter (thereby defining an annular volume). This volume where the liquid material is to be delivered defines a delivery space between each microcoil within said at least one pair of microcoils. A slope or gradient may also be measured on the horn microcoil by passing a line (with the most appropriate geometric averaging) through a point on each coil at the same rotational angle. The slope of the line drawn through points on the windings may, for example only, be between 5 and 85 degrees, between 10 and 80 degrees or between 15 and 80 degrees with respect to the axis of the coil. Other ranges such as between 5 and 70 degrees, between 10 and 60 degrees, and the like may also be used as the slope of the horn shape.

The device, in response to radiofrequency transmission, generates a reception field which has a more uniform transverse field strength within said volume bordered by planes than in a comparable volume surrounding a catheter having equally spaced windings of similar winding diameters (that is, the average winding diameters of all windings are the same). At least one horn-shape microcoil or at least one pair of microcoils may be embedded within a binder material that surrounds said lumen. At least one pair of microcoils may be electrically connected to a preamplifier within a portion of said device that may be inserted into an organism. That is, the location of the preamplifier is such that when the device is inserted into the body of a patient, the preamplifier is also inserted along with the device. As a result of some desirable methods of construction of the circuitry (e.g., photolithographic etching and deposition, mask sputtering, electrodeposition, and other like positive or negative imagewise deposition or removal of materials), electrical connections may be present and at least some of the electrical connections may have been formed *in situ* within the device.

Another way of describing a device of the present invention is as a device for use within an organism, the device comprising an element having at least one pair of opposed RF receiver microcoils having a space between the pair of microcoils. The RF receiver microcoils each comprise at least three individual windings. The at least three individual windings of said microcoils having diameters so that adjacent windings have winding diameters that increase by at least 1% with respect to an adjacent winding. The diameters may increase by at least 2%, at least 4%, at least 8%, at least 10% or more between adjacent windings, with the total increase in diameters from the smallest average diameter to the largest average diameter being from 5 to 200%, with any intermediate value (e.g., 8%, 15%, 25%, 50%, 75%, 100%, 150%, etc.) being useful.

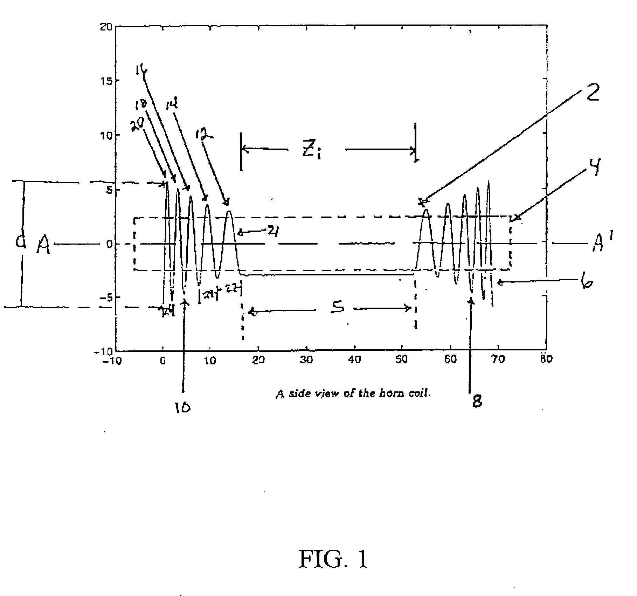

Figure 1 shows a side view of the preferred coil geometry; other choices are possible for the variability of the radius. A medical device **2** is shown comprising a catheter **4** and a microcoil element **6.** The microcoil element **6** is shown to comprise a pair of opposed microcoils **8** and **10** (although a single horn could be used, alone or in combination with a microcoil of a different configuration, such as concentric windings in an approximately planar configuration or a set of windings of coequal diameters wrapped in sequence about the core, or a series of windings being spaced as one of the windings in the pair of opposed microcoils in U.S. Patent No. 5,964,705). These shown two horn-shaped microcoils **8** and **10** are generally disposed about an axis comprising the catheter **4** and the axis **A-A=** of the catheter **4.** Looking directly down the axis **A-A=,** one coil (e.g., coil **8**) would appear to move in a counterclockwise direction about the axis **A-A=,** while looking the same direction down the axis **A-A=,** the other microcoil **10** would appear to move in a clockwise direction about the axis **A-A=**. Microcoil **10** is shown with five (5) windings (**12, 14, 16, 18** and **20**) or complete rotations of the wires **21** that comprise the microcoil **10.** The diameter **d** of the last, outermost winding **20** is shown as the outermost distance (away from the axis **A-A=**) attained in two opposite apogees in the traversal of the wires **21** in forming one complete (360 degrees) angular rotation of the windings (**12, 14, 16, 18** and **20**) of the microcoils around the core. At least two of the diameters of adjacent windings (within **12, 14, 16, 18** and **20**) are different, with at least one pair of adjacent windings (within **12, 14, 16, 18** and **20**) being of different diameters. As determined from their respective distance from an intermediate zone **Zi,** at least some adjacent microcoil windings should have increased diameters as they are farther from the intermediate zone **Zi.** The intermediate zone **Zi** in this Figure is shown as an electrical bridge between the two microcoils **8** and **10.** It is preferred that each microcoil (e.g., **8** and **10**) have at least three windings that increase in diameter as the windings move farther from the intermediate zone **Zi,** but there are no absolute upper limits to the number of windings, although certain uses might find 10, 20, 30 or fifty windings to be reasonable limits in combination with the minimum of three windings.

In Figure 1, it is also shown as an option in the practice of the present invention, as shown in U.S. Patent No. 5,964,705, the frequency or spacing (**22, 24** and **26**) between adjacent windings (e.g., within **12, 14, 16, 18** and **20**) may be different, and in this Figure 1 are shown with the distance (**22, 24** and **29** between adjacent windings (e.g., within **12, 14, 16, 18** and **20**) decreasing as the windings are positioned farther from the intermediate zone Zi. The frequency may also decrease (the separation increasing) and the diameter of the windings may decrease between adjacent windings (e.g., within **12, 14, 16, 18** and **20**) as the windings are positioned farther from the intermediate zone **Zi** as an option for special configurations and uses, or the windings may both increase and decrease in frequency and diameters for other configurations.

As is noted in Figure 1, a space **S** between microcoils is most conveniently measured along a straight line of the winding, at points on the winding with approximately the same angle of rotation and where the windings are no longer oriented in a path circumscribing the axis **A-A=.** The points from which this measurement is taken is an approximation of an end of a microcoil, with no further wrapping of the wire about the axis **A-A=.**

In Figure 1, the first coil starts to wind from a larger radius $r_1$ to a smaller radius $r_2$ with the difference between the two radii preferably ranging approximately from $0.1r_1$ to $0.7r_1$, or being represented by an at least 4% change, at least 5% change, at least 10% change, or a change of from 10% to 70% between either adjacent windings or amongst a gradiently changing group of windings in a series. The radius $r_1$ may be chosen to be as small as 0.5 mm or as large as 4 mm. While this is a preferable range for many applications, some applications may use values outside this range. As seen from the end of the coil corresponding to the larger radius, the sense of winding of the first coil is clockwise around the common coil axis. There must be at least two complete windings, usually at least three or at least four windings, and any number of windings may be used (e.g., up to 6, 8, 10, 20, and the like) with diminishing returns being eventually met. Figure 2 illustrates the sense of winding of the first coil with an end view of the same. The bridging conductor between the coils runs for a length that preferably lies in the approximate range $r_1$ to $8r_1$. The second coil starts winding in an anticlockwise sense beginning from a radius of $r_2$ with the winding radius then increasing to the value $r_1$. The radius of the helical winding in each coil may increase or decrease steadily or in stepwise fashion. Furthermore, the pitch of the winding, or the distance along the axis between two successive turns of coil, may vary along the length of each of the coils. The pitch of the very first turn of coil may range from $t$ to $r_2$, where t is the width of the conductor used in the coil. In the design shown, the pitch of each successive turn of coil increases in geometric fashion from the outer end to the inner end. This geometric ratio of successive pitch lengths may vary preferably in the approximate range from 1 to 3.5, with increasing pitch from outer to inner end being preferred. The variation in radius, as stated earlier, could preferably take various generally horn shaped forms.

Although the above description discusses a single pair of opposed coils, it is possible to use multiply wound configurations while maintaining the horn-shaped profile of the windings.

In Figure 2, looking down the coil axis **A-A=,** let the coil winding start at an orientation defined to be the 6 o'clock orientation, and this orientation will be labeled **C-C=.** Then 9 o'clock (**B-B=**), 12 o'clock (**C=-C**) and 3 o'clock (**B=-B**) orientations are defined in clockwise fashion with orientation labels **29** (**B-B=**), **28** (**C=-C**) and **31** (**B=-B**), respectively. These orientations are marked in Figure 2, where **A-A=** is the coil axis, and **B-B=** and **C-C=** are mutually perpendicular axes which are also orthogonal to **A-A=.** The shown winding angle 27 is then measured away from **C-C=,** clockwise as seen looking down **A-A=,** and **28, 29, 30** and **31** define the 6 o=clock, 3 o=clock, 12 o=clock and 9 o=clock orientations respectively, discussed just above.

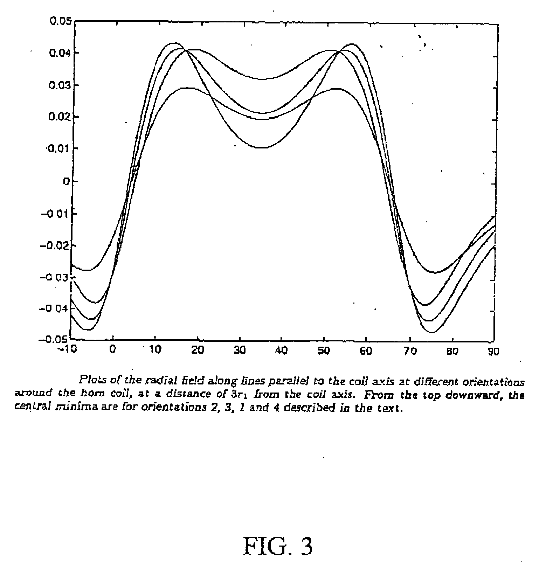

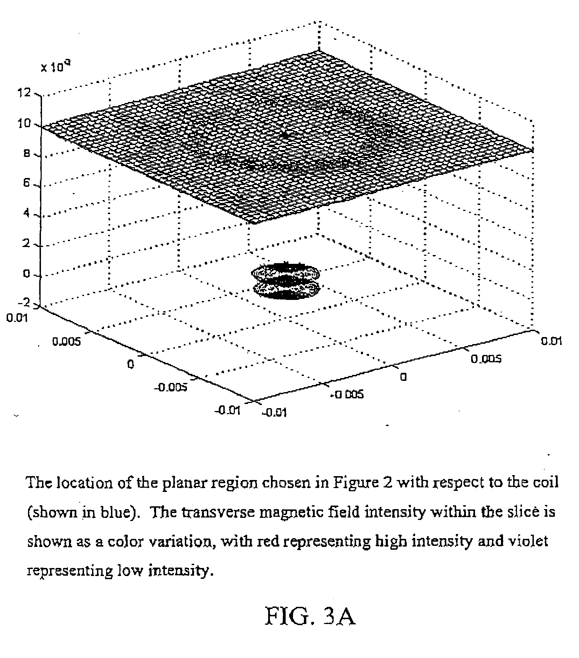

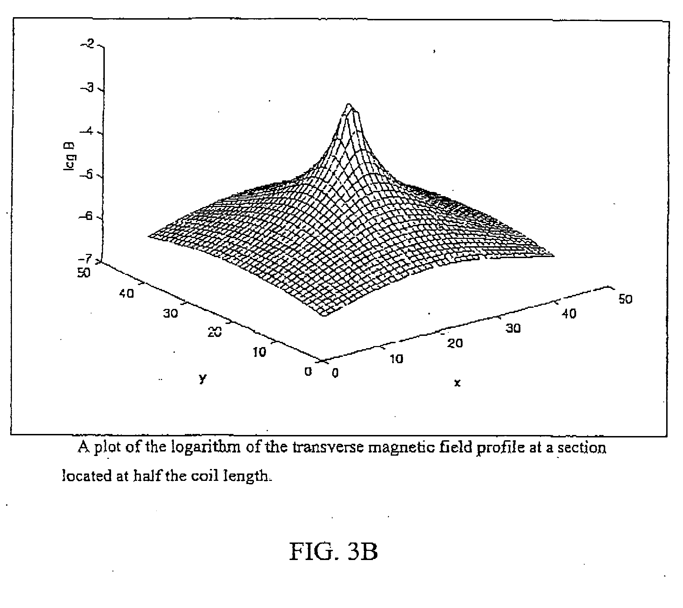

Figure 3 shows the typical radial magnetic field profiles generated by the coil along four lines parallel to the coil axis and at a distance of $3r_1$ from it, and the coil extending from 0 to approximately $14r_1$ in the axial direction. Due to the nature of the coil and the winding used, the transverse magnetic field is mostly radial.

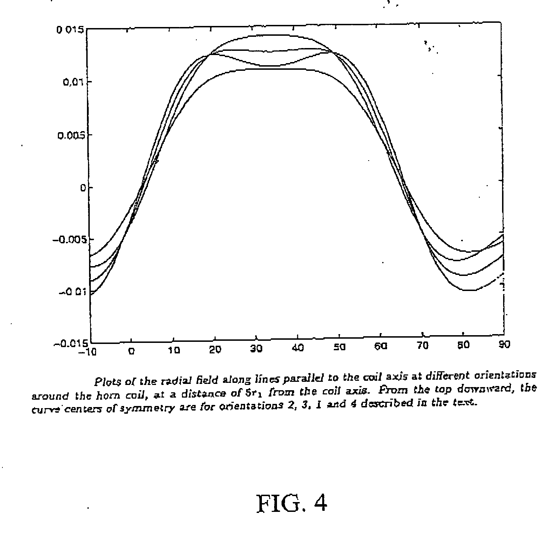

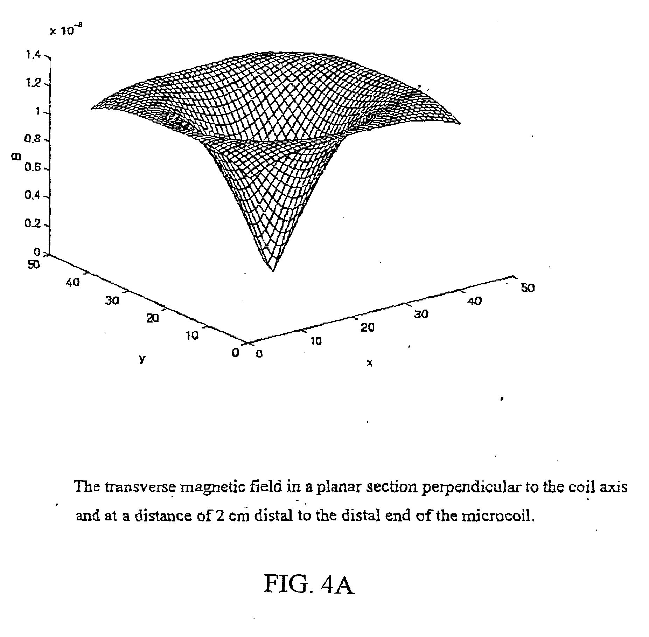

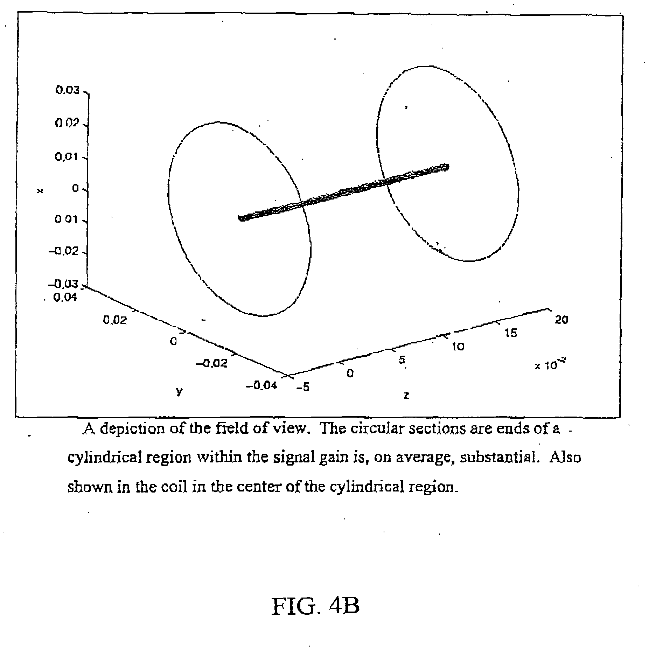

Figure 4 shows the radial field profile along lines at different orientations around the coil axis and parallel to it, at a distance of $Sr_1$ from the axis. It can be seen that the field profile does not change very much around the coil, and is uniform over a substantial fraction of the length of the coil.

Fewer than 50 number percent of windings in the practice of the present invention may, for example, intersect a single geometric plane perpendicular to a common axis between adjacent microcoils. In fact, fewer than 40%, fewer than 30%, fewer than 20%, fewer than 10% and 0% of windings within a single microcoil should intersect such a geometric plane perpendicular to said common axis.

The fabrication of the coil may be accomplished using many different methods familiar to those skilled in the art, including winding conducting wires or filaments of wire over a catheter tip whose cross sectional variation follows the horn profile, deposition and etching processes, masked deposition, microlithography, and such other techniques known to practitioners of the art, on different substrates, including flexible films, and possibly followed by rolling to achieve the final configuration of the coil geometry. The conductor may be of copper, silver, gold or other electrically highly conducting material possibly including alloys, composites or platings. The coil itself may be enclosed by or encased within tightly fitting protective or insulating material such as a polymer.

The number of turns in each of the opposed coils may range between 2 and 25, although preferably between 5 and 14. The width of the conductor used in the winding may range from 10 micrometers to 2 millimeters. The leads connecting to the ends of the coil may be arranged geometrically in such suitably convenient fashion as the specific application for which the invention is used demands.

This invention relates to medical devices for the reception of radio frequency electromagnetic radiation. These devices are used to obtain a local but very wide field-of-view magnetic resonance image of a region within a natural organism (such as within a human) or elsewhere. Medical devices such as catheters and other devices for delivery of therapeutic agents and monitoring of metabolic activity may be used together with such magnetic resonance imaging devices. The use of novel microcoil configurations in the devices alter the response characteristics of the microcoils.

In summary, while microcoils for such internal imaging have been described before, the said device here advances the art by virtue of being designed specifically to maximize the field of view as well as the signal gain within the field of view. This requires a tradeoff with homogeneity of the radial receptive field, which may however be corrected for if the receptive field (magnetic field $B$ transverse to the main MR magnetic field produced by unit current in the coil) is known. This correction may be performed by dividing the reconstructed image intensity at a given pixel location by the gain corresponding to that pixel (which is proportional to the magnetic field $B$ at that location), and repeating this for all pixels.

Microcoil designs are provided that enable unique RF response Field profiles that are particularly useful in MRI imaging procedures, particularly where fields of view outside of the medical device are desirable. These devices are particularly for use within an organism, the device comprising an element having at least one RF receiver, the coils of said microcoils defining a cross-section that lies in a plane oriented at 0 to 90 (or 0 to 80) degrees to the longest axis of the device. Another way of describing the device is as a device for use in an organism, the device comprising an element having at least one wound microcoil with at least three windings on the microcoil. Each winding has an aspect ratio of greater than one. The aspect ratio of each winding is measured as the ratio of longest to shortest dimension in a cross section situated approximately transverse to the winding axis of the coil windings, the winding axis also being transverse to the longest axis of said device

Another way of describing the device for use within an organism is as a device comprising an element having at least one RF receiver microcoil, the coils of the microcoils defining a cross-sectional contour having an alignment value of at least 0.75 with the longest axis of the device. The device may have the cross-section comprise a geometric shape, such as a curvilinear shape, a polygon (regular or irregular), or a polygon where corners on the polygon are softened (e.g., slightly rounded). The device may comprise a catheter having at least one lumen. At least one microcoil should be located with its longest dimension defining a longitudinal spatial extent (direction) parallel to the at least one lumen and the coils having a conductor thickness of greater than 0.01 mm and less than 2.4 mm.

A preferred construction uses an MR Responsive coil having a significant distribution of surface area and orientation along an axis generally parallel to the major axis (longest dimension) of an underlying medical device, such as the tube length of a catheter or stent. In particular, the coil is wound such that the cross section of the winding transverse to the winding axis possesses a high aspect ratio. The winding axis is generally transverse to the long axis of the underlying medical device. By high aspect ratio, it is meant that when viewed along the axis about which the coil is wound, the coil presents a cross section in the form of a contour whose ratio of largest width to smallest width is at least 4. The microcoil may be wound in any configuration that presents a substantial distribution parallel to the body of a major axis of the medical device. A simple example of such a construction would be to have the microcoils rectangularly wound (especially with a high aspect ratio) about the device, for example, with the coil embedded within or attached to the outside of the catheter or other device, with the long side of the rectangle being parallel to the catheter axis. Thus the coil's winding axis is transverse (e.g., between 0 and 85 degrees, or between 0 and 60 degrees or between 0 and 30 degrees) to the catheter axis (e.g., from parallel to the catheter axis to the larger degree angle). The catheter axis is essentially the axis of the catheter along its longest dimension (usually the axis of the generally cylindrical body forming the catheter),

This winding geometry creates a large field of view transverse to the catheter axis.

One general description of the practice of the present invention is included in the following text. A device according to the invention includes its use within an organism, the device comprising an element having at least one wound microcoil with an aspect ratio larger than four the winding coils of said microcoils defining a polygonal cross-section of three to twelve sides, and the aspect ratio boing defined as the ratio of largest diameter to smallest diameter of said polygonal section of said microcoil. By polygonal, it is not meant that the transition from one generally linear face to another generally linear face is necessarily a sharp angle, as there may be a generally polygonal shape with rounded transitions from one face to another. The term polygonal, unless restricted by the term "rigid polygonal" allows for generally polygonal shapes, e.g., a multiplicity of non-continuously arcing surfaces, and generally straight linear elements or faces, with rounded transitions between the generally straight linear elements or faces. For example, a square with its corners rounds up to forty percent of the length of each side would still be polygonal according to this definition. The term also includes cross-sections where the founding of the edges extends 35% or less, 30% or less, 20% or less, 10% or less, and 5% or less of each side, and rigid polygonal shapes, The device may comprise a catheter having at least one lumen, and the at least one microcoil is located with its longest dimension defining a longitudinal spatial extent parallel to said at least one lumen while the conductor making up the coils has a thickness of greater than 0.01 mm and less than 2.4mm. The device may include at least one drug delivery port present within it. The device may have the at least one drug delivery port located so that at least some drug which is delivered through said port is delivered away from the device within a volume bordered by planes extending transverse to the device at the ends of said longitudinal spatial extent The device may have microcatheters present within the device. These may extend outside of the device to deliver at least some liquid material within a volume bordered by planes extending radially from the catheters at the ends of said longitudinal spatial extent In response to radiofrequency transmission, the device may generate a reception field which has an average strength that diminishes by a factor of at least 10 from an area defined by a cylinder of 1.5 cm about a core axis of the cylindrical device to an area defined by a cylinder of 4.0 cm about the core axis of the cylindrical device. The device may have at least one high aspect ratio wound microcoil embedded within a binder material and may have the at least one high aspect ratio microcoil electrically connected to a preamplifier within a portion of the device which may be inserted into an organism. The device may also comprise an element having at least one high aspect ratio microcoil with its longest dimension transverse to its winding axis and defining a longitudinal spatial extent, the winding coils of said microcoils defining a polygonal cross-section of four to six sides.

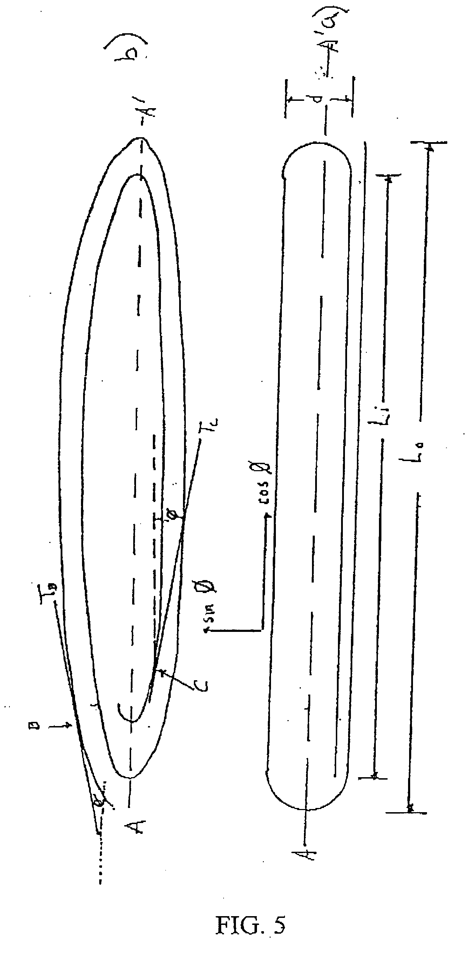

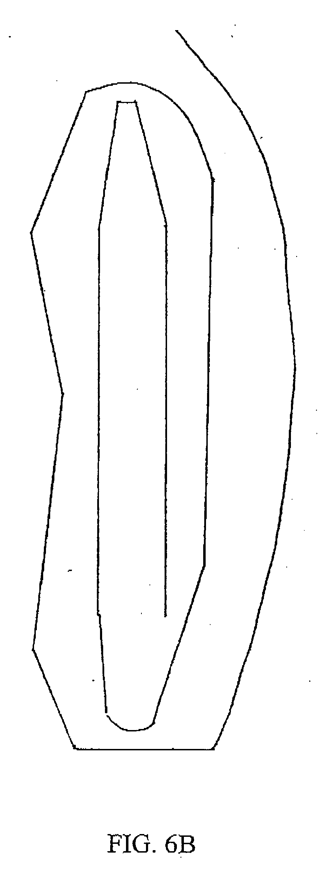

A unique feature of the present invention is the high aspect ratio of the winding in a cross section transverse to the winding axis, which allows for a large receptive field in a roughly cylindrical region surrounding the catheter axis. The gain in this cylindrical region falls off with increasing distance from the catheter axis and can be very high within a cylindrical slab of diameter about 2 cm surrounding the catheter axis. Within this slab, the gain can be as much as 100 times larger than that correspondingly obtained from a typical head coil. This choice of winding geometry also yields a very homogeneous field profile along a direction parallel to the catheter axis. While a high-aspect-ratio rectangular shape for the winding pattern is most preferred, other high-aspect-ratio geometries may also be used. These alternative designs are shown in Figures 5 and 6B. In Figure 5 the aspect ratio would be the ratio of the length (Lo) to the width or diameter (w) of the particular winding. By high aspect ratio is meant that the ratio of length to diameter in a winding is at least 4, at least 5 or higher. Configuration a) of Fig. 5 Shows the highest cosine profile and therefore the highest percent of the coil winding that would be aligned with the catheter axis (**B-B'**)- The determination of the percentage of alignment of the winding with the catheter axis is determined by a formula later described herein. This configuration a) of Fig. 5 would provide a percentage alignment of about 90% or more.

Figure 6B shows other configurations that also provide for higher winding orientation with the catheter axis. These configurations of Figs. 5(b) and 6B show that regular polygon shapes are not essential and that curvilinear shapes and irregular shapes may be used. The integration of the function of the cosine over the surface of the wire is done with regard to the angle $\phi$, measured at each point along the winding (**B** and **C**, for example) with respect to the angle $\phi$ of the tangent T at that point (e.g., $\mathbf{T_C}$ and $\mathbf{T_B}$). Greater orientation of the wire of the microcoil and the winding along with the axis of the catheter **A-A'** increases the performance due to the field configuration according to the present invention.

One way of defining the distribution of the microcoils according to the present invention is as follows. When looking at a cross-section of each winding, if $\phi$ is the angle made by the tangent to the winding at each point on it with the long axis of the device (e.g., the axis of the catheter), the integration of the absolute value of the cosine of the winding (s) with respect to the long axis of the device must equal at least 0.75. That is,

$$\text{Alignment Value (AV)} = \Sigma(|\cos \phi|)d\phi/\Sigma(d\phi)$$

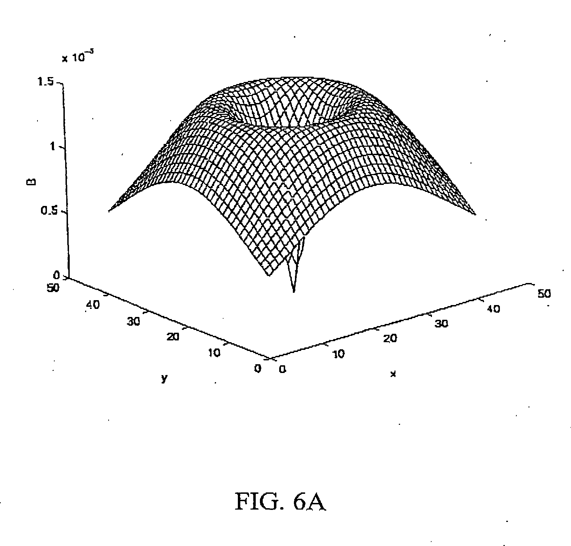

with $\Sigma$ denoting an integral taken over the length of the entire winding. It is desirable that the alignment value equals, at least 0.70, at least 0.75, at least 0.80, at least 0.85, and at least 0.90. It is not possible to have an alignment value of exactly 100% because of the need for the return of the coil, but the closer the value to 100%, the more specific is the field generated from the design. This alignment value is with respect to the integration from 0 to $2\pi$ radians about each

winding or all windings within the microcoil. This can be seen also in Figure 6A, as herein explained. A circular winding would have an alignment value of $2/\pi$ (about 0.64).

Besides the monitoring of small quantities of locally delivered therapeutic agents, including those used in gene and cell based therapies, an important application area of the microcoil described herein is the monitoring of cell and tissue function by means of magnetic resonance spectroscopy methods. These methods directly measure metabolic activity in tissue.

We will call the dimension of the entire wound coil in the y-direction with the width w of the coil and the dimension of the entire coil in the x-direction the depth d of the coil. The width of the coil is the smallest diameter presented by the coil in a section transverse to the winding axis, including the thickness of the conductor. The depth of the coil is the sum of (a) all the spacing distances between successive turns of winding and (b) the product of the number of winding turns and the conductor thickness. The aspect ratio of the microcoil **4** is the ratio ($l/w$). The length $l$ of the coil (longest dimension in the z-clirection) may vary in the range 0.5 cm to 6 cm and may more preferably lie between 1 cm and 4 cm. The width $w$ of the coil, chosen so as to fit within a catheter or affixed to the outside of a catheter, may range from 0.5mm to 6 mm, and more preferably may lie between 1 mm and 4 mm. The depth d of the entire coil (including all the winding turns and the spaces between them) may range from 0.3 to 6 mm, and more preferably may lie between 1 mm and 4.5 mm. The conductor used in the winding may be electrically highly conducting material such as copper, silver or gold, or it may be suitable alloys, composites or plated combinations of conducting materials. The thickness of the conductor used in the windings may range from 0.01 mm to 2 mm and the gap between adjacent turns of conductor may be between 0.01 mm and 1.5 mm. The number of turns in the winding may, for non-limiting example only, vary between one and fifteen, between one and ten, between two and ten, between two and eight, between three and ten and between three and eight.

The sensitivity or gain of the coil is proportional to the component of the magnetic field that is transverse to the main field of a magnetic resonance imaging system, produced by unit current flowing through the coil. We compute below the magnetic field transverse to the main field of a magnetic resonance system and produced by unit current in the microcoil for the case when its long axis is parallel to the main magnetic field. For other orientations of the microcoil with respect to the main field the magnetic field may be obtained by an appropriate rotation. The magnetic field may be determined in a specified region surrounding the coil by using the Biot-Savart law:

$$\mathbf{B} = (\mu/4\pi)\, \Sigma[(d\mathbf{l} \times \mathbf{r})/(|\mathbf{r}|^3)]$$

with the integral $\Sigma$ taken ever the entire length $L$ of the conductor in the coil, where **B** is the magnetic field at a specified point in space, $d\mathbf{l}$ is a current-carrying length element and **r** is the distance vector from the current element to the specified point.

A study of the distribution of the magnetic field around the coil is useful for assessing the field profile. In particular, with the choice of coil orientation with respect to the main magnetic field of the imaging system as stated above, it is the component of the magnetic field transverse to the main magnetic field that is relevant for signal construction. For this purpose, we have therefore mapped the transverse component of the magnetic field along sections transverse to the catheter axis, at various locations along the coil length.

Figure 2B is a plot of the logarithm of the transverse magnetic field in a 4 cm x 4 cm transverse section located at a distance of 20 % along the coil length measured from the end of the catheter with the coil terminals at that end. The five-turn coil shown in Figures 1B and 1C with approximate dimensions $l$=2 cm, $w$=2 mm, $d$=1.5 mm was used in this computation. The transverse field is very sharply peaked at the center and consequently we have illustrated the field profile in a logarithmic plot The significance of the plot is that the transverse field profile, and thence the sensitivity, is still substantial at the outer edges of this section.

Figure 3B is similar to Figure 2B except that it is the transverse field profile at a section located at the middle of the coil. It is evident from these two figures that the field profile changes very little along the length of the coil.

Figure 4B shows the size of the sensitive region in relation to that of the coil itself. The ends of the cylinder bounding this cylindrical region are shown. The signal-to-noise ratio at the edge of this region is comparable to that obtained from a typical head coil used in magnetic resonance imaging.

Figures 5. and 6B show possible variations in the winding pattern which may be followed.

This invention relates to primary medical devices for the reception of radio frequency electromagnetic radiation, particularly medical devices used to obtain a magnetic resonance image of a region in front of the device and within a natural organism or patient (such as within a human) or elsewhere, and secondary medical devices such as catheters and secondary devices for delivery of therapeutic agents and monitoring of metabolic activity. The use of magnetic resonance primary medical devices to provide enhanced imaging within the region of interest in conjunction with the deployment of secondary medical devices offers a particularly effective means of delivering targeted therapy.

While microcoils for *internal* imaging have been described before, the device of the present invention advances the state of the art by design features that maximize the field of view in a direction forward to and beyond the spatial extent of the coil itself (e.g., parallel to the axis or the core of the device), as well as improving the signal gain within this field of view. The signal power falls off with distance in the forward direction (forward being defined as a direction outwardly directed from the device along the core axis of the microcoils). For volume imaging purposes, this fall-off can be adjusted for by dividing the reconstructed image intensity at a given voxel location by the gain corresponding to that voxel (which is proportional to the magnetic field $B$ at that location), and repeating this for all voxels.

An aspect of the invention comprises a device to be inserted into a patient comprising a solid body having at least one microcoil, or at least one pair of radially opposed microcoils physically associated with the solid body, each microcoil having an outside microcoil diameter of 6mm or less, all individual windings of said each microcoil together defining a geometric plane of each microcoil, and the plane of each microcoil being parallel to the plane of another microcoil in each pair of radially opposed microcoils.

One form of construction in the practice of the present invention uses a single electrically conducting path, configured so as to yield one microcoil spiral winding or a multiplicity of pairs of spiral windings with a common coil axis, with the spirals in each pair being radially opposed. The term "radially opposed" as used in the practice of the present invention is defined as meaning that the pairs have their windings positioned in the sense that one member of each spiral pair winds radially inward and the other member of the pair winds radially outward about the coil axis (when moving along the length of a continuous electrical path). There cannot be an intermediate coil between the two coils of the pair of radially opposed coils that has an opposite winding sense if those two microcoils are to be considered 'radially opposed' in the practice of the invention, or those adjacent coils would not be radially opposed with a uniform sense of winding. The term "radially-opposed" will be used to describe this arrangement of each spiral pair (that is a pair on a common coil axis) with the spirals in each pair being radially opposed in the sense that one member of each spiral pair winds radially inward and the other member of the pair winds radially outward about the coil axis when considered along a common, continuous electrical path. The electrical path need not be continuous (e.g., the same current passing through one microcoil and then the other in the path) for a radially opposed pair to be formed. For example, there may be two separate conductive paths from the same direction. One electrically conductive path may connect to the exterior winding of a microcoil, and the other electrically conductive path may connect to the interior winding of the adjacent microcoil. These adjacent microcoils could then be considered radially opposed. It is important to note, however, that the *sense* of the winding of each of the spirals in the entire configuration or at least at one end of a configuration or at one end of a device is the same (all clockwise or all anti-clockwise about the coil axis as seen from the proximal end of the coil, looking down the axis).

In the practice of the present invention, the direction pointing along the catheter (or microcoil) axis from the proximal end of the microcoil to the distal end of the microcoil will be referred to as the '*forward*' direction. The forward direction will often be associated with the forward tip of the catheter or medical element also. The large forward extension of the field of view and the high sensitivity of the coil in a significantly larger region within the field of view constitute a substantial advance in the design of magnetic resonance microcoils.

## Claims

1. A device (2) adapted for insertion within an organism during a magnetic resonance procedure, said device (2) comprising:

   a RF coil for magnetic resonance imaging adapted for use on a device to be inserted into a patient, the RF coil comprising:

   at least one pair of coils (8,10) being wound in helical and in opposite sense;
   said pair of coils (8,10) being arranged along a common longitudinal axis;
   said pair of coils (8,10) having a space (S) along said common longitudinal axis between them;
   said RF coil being **characterized in that:**

   the winding diameter of each coil increases with increasing actual distance from the other coil from said pair of coils (8,10).

2. The device of claim 1 wherein said device (2) comprises a catheter (4, Fig 1) having at least one lumen, wherein bath coils of said pair of microcoils (8,10) have at least one adjacent pair of windings in which a diameter of one winding on the each microcoil in said pair of microcoils (8,10) increases in winding diameter with respect to a diameter of an adjacent winding on that microcoil and said at least one pair of microcoils (8,10) is radially located about said at least one lumen and said windings have diameters of greater than 0.1 mm.

3. The device of claim 2 adapted for insertion within an organism during a magnetic resonance procedure, said device (2) comprising:

an element (6) having at least one pair of opposed, non-uniformly-cylindrical, coaxial RF receiver microcoils (8,10) having a space (S) between the pair of opposed microcoils, said RE receiver microcoils (8,10) each comprising at least three individual windings, said at least three individual windings of said microcoils having diameters so that adjacent windings have winding diameters that increase by at least 1% with respect to an adjacent winding dose to the space between the pair of opposed microcoils (8,10).

4. The device of claim 2 adapted for insertion within an organism during a magnetic resonance procedure, said device (2) comprising: at least one pair of non-uniformly-cylindrical coaxial receiver microcoils (8,10) arranged in opposed fashion, the microcoils arranged in a multiply wound configuration about the coil axis, the microcoils having a space between each microcoil of said at least one pair of microcoils, at least one of the coils of said microcoils having at least one pair of adjacent windings on at least one microcoil in which a diameter of said at least one winding on the at least one microcoil increases in winding diameter with respect to a diameter of an adjacent winding.

5. The device according to claim 1 wherein in the presence of a continuous electrical path, at least one pair of radially opposed microcoils (8,10) form a spiral pair wherein one microcoil of every spiral pair is wound radially inward and the other microcoil of that pair is wound radially outward about the coil axis, with all microcoils of the spiral pair having the same sense of winding about a common axis of the spiral pair.

6. The device of claim 5 adapted to be inserted into a patient, the device (2) comprising a solid body having at least one pair of opposed microcoils (8,10) physically associated with the solid body, each microcoil having an outside microcoil diameter of 6 mm or less, collective individual windings of said each microcoil defining a geometric plane, and the plane of each microcoil being parallel to the plane of another microcoil in the pair of opposed microcoils.

7. The device of claim 5 adapted to be inserted into a patient, the device (2) comprising a solid body having at least one microcoil physically associated with the solid body, each microcoil having an outside microcoil diameter of 6 mm or less and a common axis, with at least one microcoil physically associated with the solid body at a distal end, at least 50% of individual windings of said each microcoil lying within a geometric plane perpendicular to said common axis.

**Patentansprüche**

1. Vorrichtung (2), die für das Einsetzen innerhalb eines Organismus während eines Magnetresonanzverfahrens eingerichtet ist, wobei die Vorrichtung (2) Folgendes umfasst:

eine HF-Spule für die Magnetresonanzbildgebung, die für eine Verwendung an einer in einen Patienten einzusetzenden Vorrichtung eingerichtet ist, wobei die HF-Spule Folgendes umfasst:

wenigstens ein Paar von Spulen (8, 10), die in spiralförmiger und in entgegengesetzter Richtung gewickelt sind,

wobei das Paar von Spulen (8, 10) längs einer gemeinsamen Längsachse angeordnet ist,
wobei das Paar von Spulen (8, 10) einen Raum (S) längs der gemeinsamen Längsachse zwischen denselben hat,
wobei die HF-Spule **dadurch gekennzeichnet ist, dass**:

der Wicklungsdurchmesser jeder Spule mit einem zunehmenden tatsächlichen Abstand von der anderen Spule von dem Paar von Spulen (8, 10) zunimmt.

2. Vorrichtung nach Anspruch 1, wobei die Vorrichtung (2) einen Katheter (4, Fig. 1) umfasst, der wenigstens ein Lumen hat, wobei die beiden Spulen des Paares von Mikrospulen (8, 10) wenigstens ein benachbartes Paar von Wicklungen haben, wobei ein Durchmesser einer Wicklung an jeder Mikrospule in dem Paar von Mikrospulen (8, 10) im Wicklungsdurchmesser in Bezug auf einen Durchmesser einer benachbarten Wicklung auf dieser Mikrospule zunimmt, und wobei das wenigstens eine Paar von Mikrospulen (8, 10) in Radialrichtung um das wenigstens eine Lumen angeordnet ist und die Wicklungen Durchmesser von mehr als 0,1 mm haben.

3. Vorrichtung nach Anspruch 2, die für das Einsetzen innerhalb eines Organismus während eines Magnetresonanzverfahrens eingerichtet ist, wobei die Vorrichtung (2) Folgendes umfasst:

ein Element (6), das wenigstens ein Paar von einander gegenüberliegenden, nicht gleichförmig zylindrischen, koaxialen HF-Empfänger-Mikrospulen (8, 10) hat, das einen Raum (S) zwischen dem Paar von einander gegenüberliegenden Mikrospulen hat, wobei die HF-Empfänger-Mikrospulen (8, 10) jeweils wenigstens drei einzelne Wicklungen umfassen, wobei die wenigstens drei einzelnen Wicklungen der Mikrospulen Durchmesser haben derart, dass benachbarte Wicklungen Wicklungsdurchmesser haben, die um wenigstens 1 % in Bezug auf eine benachbarte Wicklung, nahe dem Raum zwischen dem Paar von einander gegenüberliegenden Mikrospulen (8, 10), zunehmen.

4. Vorrichtung nach Anspruch 2, die für das Einsetzen innerhalb eines Organismus während eines Magnetresonanzverfahrens eingerichtet ist, wobei die Vorrichtung (2) Folgendes umfasst: wenigstens ein Paar von nicht gleichförmig zylindrischen koaxialen Empfänger-Mikrospulen (8, 10), die auf einander gegenüberliegende Weise angeordnet sind, wobei die Mikrospulen in einer mehrlagig gewickelten Konfiguration um die Spulenachse angeordnet sind, wobei die Mikrospulen einen Raum zwischen jeder Mikrospule des wenigstens einen Paares von Mikrospulen haben, wobei wenigstens eine der Spulen der Mikrospulen wenigstens ein Paar von benachbarten Wicklungen auf wenigstens einer Mikrospule hat, wobei ein Durchmesser der wenigstens einen Wicklung auf der wenigstens einen Mikrospule im Wicklungsdurchmesser in Bezug auf einen Durchmesser einer benachbarten Wicklung zunimmt.

5. Vorrichtung nach Anspruch 1, wobei beim Vorhandensein eines durchgehenden elektrischen Pfades wenigstens ein Paar von einander in Radialrichtung gegenüberliegenden Mikrospulen (8, 10) ein Spiralpaar bilden, wobei die eine Mikrospule jedes Spiralpaares in Radialrichtung nach innen gewickelt ist und die andere Mikrospule dieses Paares in Radialrichtung nach außen um die Spulenachse gewickelt ist, wobei alle Mikrospulen des Spiralpaares die gleiche Wicklungsrichtung um eine gemeinsame Achse des Spiralpaares haben.

6. Vorrichtung nach Anspruch 5, die für das Einsetzen innerhalb eines Patienten eingereichtet ist, wobei die Vorrichtung (2) einen massiven Körper umfasst, der wenigstens ein Paar von einander gegenüberliegenden Mikrospulen (8, 10) hat, die physisch mit dem massiven Körper verbunden sind, wobei jede Mikrospule einen Mikrospulenaußendurchmesser von 6 mm oder weniger hat, wobei die einzelnen Wicklungen jeder Mikrospule gemeinsam eine geometrische Ebene definieren und wobei die Ebene jeder Mikrospule parallel zu der Ebene einer anderen Mikrospule in dem Paar von einander gegenüberliegenden Mikrospulen ist.

7. Vorrichtung nach Anspruch 5, die für das Einsetzen innerhalb eines Patienten eingerichtet ist, wobei die Vorrichtung (2) einen massiven Körper umfasst, der wenigstens eine Mikrospule hat, die physisch mit dem massiven Körper verbunden ist, wobei jede Mikrospule einen Mikrospulenaußendurchmesser von 6 mm oder weniger und eine gemeinsame Achse hat, wobei die wenigstens eine Mikrospule an einem distalen Ende physisch mit dem massiven Körper verbunden ist, wobei wenigstens 50 % der einzelnen Wicklungen jeder Mikrospule innerhalb einer geometrischen Ebene, senkrecht zu der gemeinsamen Achse, liegen.

**Revendications**

1. Dispositif (2) adapté pour être inséré dans un organisme au cours d'une procédure par résonance magnétique, ledit dispositif (2) comprenant :

une bobine RF pour une imagerie par résonance magnétique, adaptée pour être utilisée sur un dispositif destiné à être inséré dans un patient, la bobine RF comprenant :

au moins une paire de bobines (8,10) enroulées dans un sens hélicoïdal et opposé ;
ladite paire de bobines (8, 10) étant agencée le long d'un axe longitudinal commun ;
ladite paire de bobines (8, 10) comportant un espace (S) établi entre elles le long dudit axe longitudinal commun ;
ladite bobine RF étant **caractérisée en ce que** :

le diamètre d'enroulement de chaque bobine est accru en fonction de l'accroissement de la distance effective par rapport à l'autre bobine de ladite paire de bobines (8, 10).

**2.** Dispositif selon la revendication 1, dans lequel ledit dispositif (2) comprend un cathéter (4, figure 1), comportant au moins une lumière, les deux bobines de ladite paire de microbobines (8, 10) comportent au moins une paire d'enroulements adjacents, le diamètre d'un enroulement sur chaque microbobine dans ladite paire de microbobines (8, 10) correspondant à un diamètre d'enroulement accru par rapport à un diamètre d'un enroulement adjacent sur ladite microbobine, ladite au moins une paire de microbobines (8, 10) étant agencée radialement autour de ladite au moins une lumière, lesdits enroulements ayant des diamètres supérieurs à 0,1 mm.

**3.** Dispositif selon la revendication 2, adapté pour être inséré dans un organisme au cours d'une procédure par résonance magnétique, ledit dispositif (2) comprenant :

un élément (6) comportant au moins une paire de microbobines de réception RF coaxiales opposées et non uniformément cylindriques (8, 10), avec un espace (S) entre la paire des microbobines opposées, lesdits microbobines de réception RF (8, 10) comprenant chacune au moins trois enroulements individuels, lesdits au moins trois enroulements individuels desdites microbobines ayant des diamètres tels que les enroulements adjacents ont des diamètres d'enroulement accrus d'au moins 1% par rapport à celui d'un enroulement adjacent près de l'espace entre la paire de microbobines opposées (8, 10).

**4.** Dispositif selon la revendication 2, adapté pour être inséré dans un organisme au cours d'une procédure par résonance magnétique, ledit dispositif (2) comprenant :

au moins une paire de microbobines de réception coaxiales non uniformément cylindriques (8 , 10), agencées de manière opposée, les microbobines étant agencées dans une configuration à enroulements multiples autour de l'axe de la bobine, les microbobines comportant un espace entre chaque microbobine de ladite au moins une paire de microbobines, au moins une des bobines desdites microbobines comportant au moins une paire d'enroulements adjacents sur au moins une microbobine, un diamètre dudit au moins un enroulement sur la au moins une microbobine correspondant à un diamètre d'enroulement accru par rapport à un diamètre d'un enroulement adjacent.

**5.** Dispositif selon la revendication 1, dans lequel, en présence d'un trajet électrique continu, au moins une paire de microbobines radialement opposées (8, 10) forment une paire de spirales, une microbobine pour chaque paire de spirale étant enroulée radialement vers l'intérieur, l'autre microbobine de ladite paire étant enroulée radialement vers l'extérieur autour de l'axe de la bobine, toutes les microbobines de la paire de spirales présentant le même sens d'enroulement autour d'un axe commun de la paire de spirales.

**6.** Dispositif selon la revendication 5, adapté pour être inséré dans un patient, le dispositif (2) comprenant un corps massif, comportant au moins une paire de microbobines opposées (8, 10), associées physiquement au corps massif, chaque microbobine ayant un diamètre extérieur de microbobine de 6 mm ou moins, des enroulements individuels collectifs de chaque dite microbobine définissant un plan géométrique, le plan de chaque microbobine étant parallèle au plan d'une autre microbobine dans la paire de microbobines opposées.

**7.** Dispositif selon la revendication 5, adapté pour être inséré dans un patient, le dispositif (2) comprenant un corps massif, comportant au moins une microbobine associée physiquement au corps massif, chaque microbobine ayant un diamètre extérieur de microbobine de 6 mm ou moins et un axe commun, au moins une microbobine étant associée physiquement au corps massif au niveau d'une extrémité distale, au moins 50% des enroulements individuels de chaque dite microbobine étant situés dans un plan géométrique perpendiculaire audit axe commun.

A side view of the horn coil.

# FIG. 1

A three dimensional view of the horn coil, with connecting leads not shown for clarity. The changing size of the cross section is clear in this depiction.

FIG. 2

The transverse magnetic field in a planar section perpendicular to the coil axis and at a distance of 1 cm distal to the distal end of the microcoil.

FIG. 2A

A plot of the logarithm of the transverse magnetic field profile at a section located at 0.2 times the coil length.

FIG. 2B

*Plots of the radial field along lines parallel to the coil axis at different orientations around the horn coil, at a distance of $3r_1$ from the coil axis. From the top downward, the central minima are for orientations 2, 3, 1 and 4 described in the text.*

FIG. 3

The location of the planar region chosen in Figure 2 with respect to the coil (shown in blue). The transverse magnetic field intensity within the slice is shown as a color variation, with red representing high intensity and violet representing low intensity.

## FIG. 3A

A plot of the logarithm of the transverse magnetic field profile at a section located at half the coil length.

FIG. 3B

*Plots of the radial field along lines parallel to the coil axis at different orientations around the horn coil, at a distance of $5r_1$ from the coil axis. From the top downward, the curve centers of symmetry are for orientations 2, 3, 1 and 4 described in the text.*

# FIG. 4

The transverse magnetic field in a planar section perpendicular to the coil axis and at a distance of 2 cm distal to the distal end of the microcoil.

FIG. 4A

A depiction of the field of view. The circular sections are ends of a - cylindrical region within the signal gain is, on average, substantial. Also shown in the coil in the center of the cylindrical region.

FIG. 4B

FIG. 5

FIG. 6A

FIG. 6B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6026316 A
- US 6061587 A
- US 5271400 A

- US 9817076 W
- WO 9910035 A
- US 5964705 A

**Non-patent literature cited in the description**

- **A.J. Martin ; D.B. Plewes ; R.M. Henkelman.** AMR imaging of blood vessels with an intravascular coil. *J. Mag. Res. Imag.,* 1992, vol. 2, 421-429

- **E. Atalar et al.** High resolution MRI and MRS by using a catheter receiver coil. *Mag. Res. Med.,* 1996, vol. 36, 596-605